# EUROPEAN PATENT SPECIFICATION

(11) **EP 2 423 976 B1**
(45) Date of publication and mention of the grant of the patent: **15.07.2020**
(21) Application number: 10827108.1
(22) Date of filing: 28.10.2010
(51) Int. Cl.: H01L 31/048, H01L 31/0475

(54) **SOLAR PHOTOVOLTAIC DEVICE**
PHOTOVOLTAIKVORRICHTUNG
DISPOSITIF PHOTOVOLTAÏQUE SOLAIRE

(30) Priority: 28.10.2009 KR 20090103078
(43) Date of publication of application: 29.02.2012
(73) Proprietor: LG Innotek Co., Ltd., Seoul, 04637 (KR)
(72) Inventor: LEE, Dong Keun, Seoul 100-714 (KR); SUNG, Myoung Seok, Seoul 100-714 (KR)
(74) Representative: Novagraaf Technologies
(86) International application number: PCT/KR2010/007492
(87) International publication number: WO 2011/053024

(56) References cited:
- EP-A1- 1 830 411
- EP-A2- 1 713 131
- JP-A- S61 280 677
- JP-A- 2000 269 535
- KR-A- 19980 024 614
- KR-A- 20070 072 985
- KR-A- 20090 031 223

## Description

### BACKGROUND

The present disclosure relates to a solar cell apparatus.

Solar cell modules for converting light energy to electric energy by using a photoelectric conversion effect are widely used as a means for obtaining environmentally friendly energy contributing to the earth environment preservation.

As the photoelectric conversion efficiency of a solar cell is improved, various solar cell systems including solar cell modules have been installed for residential use.

Patent document EP 1 713 131 discloses a photovoltaic module. A transparent filling material with a high soften temperature, formed by thermoplastic ethylene vinyl acetate (EVA), is disposed to surround each of the photovoltaic devices. The front and back surfaces of the photovoltaic devices are covered with a filling material with a low soften temperature formed by thermoplastic EVA.

### SUMMARY

The present invention is defined by the scope of the appended claims.

Embodiments provide a solar cell apparatus with enhanced performance which facilitates recycling.

In one embodiment, a solar cell apparatus according to an embodiment includes a solar cell panel including a central region and an outer region surrounding the central region; a first adhesive member adhered to the central region; and a second adhesive member adhered to the outer region and having an adhesive strength greater than the first adhesive member.

In another embodiment, a solar cell apparatus according to an embodiment includes: a solar cell panel; a buffer member making direct contact with a top surface of the solar cell panel; an adhesive member disposed on the solar cell panel and making contact with an surrounding region of the buffer member in a top surface of the solar cell panel; and a protective panel disposed on the buffer member and the adhesive member.

In a further embodiment, a solar cell apparatus according to an embodiment includes: a solar cell panel including a central region and an outer region around the central region; an attachable member disposed on the central region; an adhesive member adhered to the outer region; and a protective panel covering the attachable member and the adhesive member.

The details of one or more embodiments are set forth in the accompanying drawings and the description below. Other features will be apparent from the description and drawings, and from the claims.

### BRIEF DESCRIPTION OF THE DRAWINGS

Fig. 1 is an exploded perspective view illustrating a solar cell module according to an embodiment.
Fig. 2 is a plane view illustrating a solar cell module according to an embodiment.
Fig. 3 is a cross-sectional view taken along line A-A' of Fig. 2.
Fig. 4 is a cross-sectional view illustrating a solar cell module according to another embodiment.
Fig. 5 is a cross-sectional view illustrating a solar cell module according to still another embodiment.

### DETAILED DESCRIPTION OF THE EMBODIMENTS

In the description of embodiments, it will be understood that when a substrate, a layer, a film, or an electrode is referred to as being 'on' or 'under' another substrate, layer, film, or electrode, the terminology of 'on' and 'under' includes both the meanings of 'directly' and 'indirectly'. Further, the reference about 'on' and 'under' each component layer will be made on the basis of drawings. In addition, the sizes of elements and the relative sizes between elements may be exaggerated for further understanding of the present disclosure.

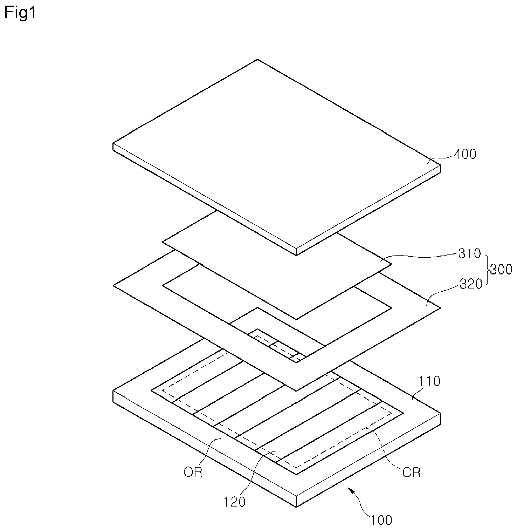

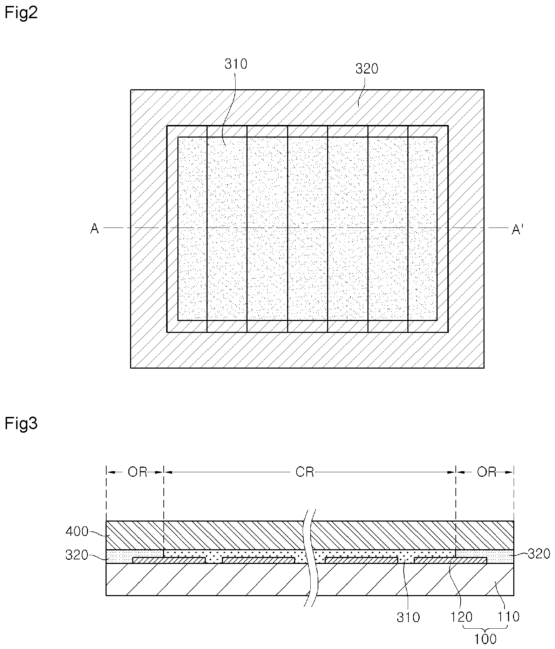

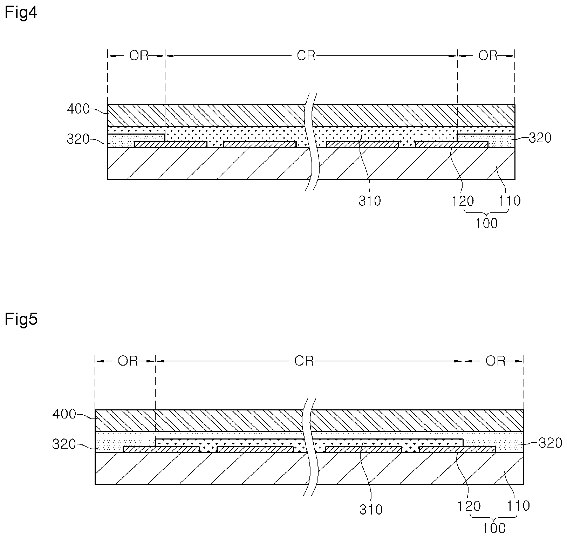

Fig. 1 is an exploded perspective view illustrating a solar cell module according to an embodiment. Fig. 2 is a plane view illustrating a solar cell module according to an embodiment. Fig. 3 is a cross-sectional view taken along line A-A' of Fig. 2. Fig. 4 is a cross-sectional view illustrating a solar cell module according to another embodiment. Fig. 5 is a cross-sectional view illustrating a solar cell module according to still another embodiment.

Referring to Figs. 1 to 3, a solar cell module according to an embodiment includes a solar cell panel 100, an adhesive member 300, and a protective panel 400.

The solar cell panel 100 has a plate shape. The solar cell panel 100 includes a central region CR and an outer region OR. The central region CR is defined as being a central portion of the solar cell panel 100, and the outer region OR is defined around the central region CR.

The solar cell panel 100 may be separated by the central region and the outer region OR. The solar cell panel 100 includes a support substrate 110 and a plurality of solar cells 120.

The support substrate 110 has a plate shape. The support substrate 110 is an insulator. The support substrate 110 may be rigid or flexible. For example, the support substrate 110 may be a soda lime glass substrate. Also, the support substrate 110 supports the solar cells 120.

The solar cells 120 are disposed on the support substrate 110. As illustrated in the drawings, the solar cells 120 may be disposed over the central region CR and the out region OR.

Alternatively, the solar cells 120 are disposed only on the central region CR.

The solar cells 120 receive solar light to convert the solar light to electric energy. The solar cells 120 are connected in series. And also, the solar cells 120 may have a shape extending to one direction.

For example, the solar cells 120 may be copper indium gallium selenide (CIGS) based solar cells, silicon based solar cells, or dye-sensitized solar cells.

The adhesive member 300 is disposed on the solar cell panel 100. The adhesive member 300 is disposed between the solar cell panel 100 and the protective panel 400. The adhesive member 300 adheres the solar cell panel 100 to the protective panel 400. That is, the adhesive member 300 is adhered to the top surface of the solar cell panel 100 and the bottom surface of the protective panel 400.

The adhesive member 300 includes a first adhesive member 310 and a second adhesive member 320.

The first adhesive member 310 is disposed on the central region CR. The first adhesive member 310 is disposed corresponding to the central region CR. The first adhesive member 310 adheres the central portion of the solar cell panel 100 to the central portion of the protective panel 400.

The first adhesive member 310 may be adhered to the central region CR. The first adhesive member 310 has a relatively low adhesive strength. That is, the first adhesive member 310 has an adhesive strength less than the second adhesive member 320. In more detail, an adhesive strength between the first adhesive member 310 and the solar cell panel 100 is low.

Thus, the first adhesive member 310 and the solar cell panel 100 are easily attachable/detachable. That is, the first adhesive member 310 is easily attachable/detachable to/from the solar cell panel 100 without the solar cells 120 being damaged.

The first adhesive member 310 may have a rectangular shape in terms of the plane. And also, the first adhesive member 310 is disposed inside the second adhesive member 320.

Ethylene vinyl acetate or polyurethane based adhesive may be used as the first adhesive member 310.

In this case, ethylene vinyl acetate which is used in the first adhesive member 310 have a relatively low content of vinyl acetate. For example, ethylene vinyl acetate which is used in the first adhesive member 310 have a relatively low content of vinyl acetate of about 15 wt% to about 40 wt%.

That is, to form ethylene vinyl acetate which is used in the first adhesive member 310, monomers or oligomers having about 15 wt% to about 40 wt% of vinyl acetate may be polymerized.

The first adhesive member 310 covers almost all of the solar cells 120. In more detail, the first adhesive member 310 may cover all of the solar cells 120.

The second adhesive member 320 is disposed on the outer region OR. The second adhesive member 320 has a closed-loop shape. For example, the second adhesive member 320 may have a rectangular loop shape in terms of the plane.

The second adhesive member 320 is disposed between the solar cell panel 100 and the protective panel 400. And also, the second adhesive member 320 is adhered to the bottom surface of the protective panel 400 and the top surface of the solar cell panel 100. The second adhesive member 320 is adhered to the outer region OR.

The second adhesive member 320 is disposed corresponding to the outer of the solar cell panel 100. That is, the second adhesive member 320 is disposed corresponding to the sides of the solar cell panel 100. That is, the adhesive member 320 may be disposed on the top surface of the solar cell panel 100 and have a shape extending along the sides of the solar cell panel 100.

The second adhesive member 320 may be adhered to some of the solar cells 120.

Alternatively, the second adhesive member 320 may be adhered only to an area in which the solar cells 120 are not disposed. That is, the second adhesive member 320 may not be adhered to the solar cells 120.

The second adhesive member 320 has a relatively high adhesive strength. That is, the second adhesive member 320 is adhered to the solar cell panel 100, with a high adhesive strength. The second adhesive member 320 has an adhesive strength much greater than the first adhesive member 310.

That is, the second adhesive member 320 is strictly adhered to the solar cell panel 100, with a high adhesive strength. Thus, the solar cells 120 may be damaged when the second adhesive member 320 is attached/detached to/from the solar cell panel 100.

Ethylene vinyl acetate, a ceramic based adhesive, or an epoxy based adhesive may be used as the second adhesive member 320.

In this case, ethylene vinyl acetate which is included in the second adhesive member 320 may have a relatively low content of vinyl acetate. That is, ethylene vinyl acetate which is included in the second adhesive member 320 may have a content of vinyl acetate greater than ethylene vinyl acetate which is included in the first adhesive member 310.

For example, ethylene vinyl acetate which is included in the second adhesive member 320 may have about 40 wt% to about 60 wt% of vinyl acetate.

The second adhesive member 320 may be a sealing member for sealing the space between the solar cell panel 100 and the protective panel 400. And also, the second adhesive member 310 may be a buffer member absorbing a shock which is applied from the outside through the protective panel 400. Furthermore, the first adhesive member 310 may not have an adhesive strength, but a buffer function.

That is, the second adhesive member 320 usually may protect the solar cells 120 from an external chemical shock such as humidity and/or oxygen. And also, the first adhesive member 310 usually may protect the solar cells 120 from an external physical shock.

The protective panel 400 is disposed on the adhesive member 300. The protective panel 400 is disposed on the solar cell panel 100. The protective panel 400 protects the solar cells 120 from an external physical shock and/or alien substances. The protective panel may be transparent and, for example, include tempered glass.

And also, another buffer layer may be disposed between the protective panel 400 and the adhesive member 300. In this case, the buffer layer may be transparent, and formed of an elastic polymer such as ethylene vinyl acetate (EVA) .

Although not illustrated, the solar cell module according to an embodiment may further comprise a frame, bus bar, junction box, and cable.

The frame accommodates and supports the solar cell panel 100 and the protective panel 400. The frame fixes the support substrate and the protective panel 400.

The bus bar may be coupled to the top surface of the solar cell 120 and be connected to a circuit board in the junction box through wiring.

The junction box may be disposed on the bottom surface of the support substrate 110. The junction box may accommodate the circuit board with the diode installed therein. The solar cell module according to an embodiment, the cable is extended from the junction box. The cable is coupled to the bus bar through the circuit board accommodated in the junction box. And also, the cable is connected to another solar cell module.

In the solar cell module according to an embodiment, the first adhesive member 310 having a relatively low adhesive strength is disposed on the central region CR, and is adhered to the solar cell panel 100 and the protective panel 400. Moreover, the first adhesive member 310 covers almost all of the solar cells 120.

Thus, the first adhesive member 310 is easily attachable/detachable to/from the solar cell panel, and when the first adhesive member 310 is attached/detached to/from the solar cell panel 100, the solar cells 120 are barely damaged.

And also, since the second adhesive member 320 has a closed-loop shape and strong adhesive strength, a sealing area may be strictly formed between the solar cell panel 100 and the protective panel 400. Thus, an external alien substance is prevented from permeating the solar cell panel 100.

Accordingly, the solar cell module according to an embodiment is easily attachable/detachable to/from the first adhesive member 310 as the damage of the solar cell is minimized.

Thus, the solar cell module according to an embodiment can prevent performance degradation due to alien substances.

As illustrated in Fig. 4, the first adhesive member 310 may cover the second adhesive member 320. That is, the first adhesive member 310 may be disposed in the outer region OR in addition to the central region CR.

A portion of the first adhesive member 310 is disposed between the second adhesive member 320 and the protective panel 400. That is, a portion of the first adhesive member 310, which is disposed in the outer region OR, may be directly contacted to the top surface of the second adhesive member 320 and the bottom surface of the protective panel 400.

In the solar cell module of Fig. 4, the first adhesive member 310 and the second adhesive member 320 may be easily attached onto the solar cell panel 100. That is, unlike in Figs. 1 to 3, in the solar cell module of Fig. 4, the first adhesive member 310 is not necessary to be aligned inside the second adhesive member 320.

Accordingly, the solar cell module of Fig. 4 having performance equivalent to the solar cell module of Figs. 1 to 3 can be easily manufactured.

And also, as illustrated in Fig. 5, the second adhesive member 320 may cover the first adhesive member 310. That is, the second adhesive member 320 may entirely cover the top surface of the solar cell panel 100.

In this case, the second adhesive member 320 is contacted with the outer region OR directly, but not the central region CR. That is, the first adhesive member 310 is disposed between the second adhesive member 320 and the central region CR.

And also, the first adhesive member 310 is adhered to the protective panel 400 through the second adhesive member 320. Thus, the first adhesive member 310 may be strictly adhered to the protective panel 400.

Furthermore, the first adhesive member 310 and the second adhesive member 320 are not necessary to be aligned to each other, thereby easily manufacturing the solar cell module of Fig. 5.

In the solar cell apparatus according to an embodiment, the protective panel can be adhered only to the outer portion of the solar cell panel, using the second adhesive member of a closed-loop shape.

And also, in the solar cell apparatus according to an embodiment, the protective panel can be adhered only to the central portion of the solar cell panel, using the first adhesive member with a relatively low adhesive strength.

Thus, since the adhesive strength in the central portion is low, the first adhesive member and solar cell panel are easily attachable to each other.

That is, since the protective panel and the central portion of the solar cell panel are attached to the attachable member, most of the solar cells are attached to the attachable member. Thus, the solar cell apparatus according to an embodiment is recyclable. Then, the attachable member or the first adhesive member can be removed without most of the solar cells being damaged. Thus, in the solar cell apparatus according to an embodiment, the solar cells are effectively recyclable.

Furthermore, the outer region is adhered using a second adhesive member with a high adhesive strength, and thus solar cell apparatus according to an embodiment can easily prevent permeation of alien substance.

The solar cell module according to an embodiment is used in the solar cell field.

Any reference in this specification to " one embodiment," " an embodiment," " exemplary embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with others of the embodiments.

## Claims

1. Solar cell apparatus comprising:
a solar cell panel (100) comprising a central region (CR) and an outer region (OR) surrounding the central region (CR),
a first adhesive member (310) adhered to the central region (CR), and
a second adhesive member (320) adhered to the outer region (OR) and having an adhesive strength greater than the first adhesive member (310),
wherein the first adhesive member (310) and the second adhesive member (320) are formed of ethylene vinyl acetate, and
**characterized in that** the ethylene vinyl acetate of the first adhesive member (310) has a content of vinyl acetate less than the ethylene vinyl acetate of the second adhesive member (320) .

2. Solar cell apparatus of claim 1,
wherein the ethylene vinyl acetate of the first adhesive member (310) comprises 15 wt% to 40 wt% of vinyl acetate,
wherein the ethylene vinyl acetate which is of the second adhesive member (320) has 40 wt% to 60 wt% of vinyl acetate

3. Solar cell apparatus of claim 1, wherein the second adhesive member (320) has a closed-loop shape.

4. Solar cell apparatus of claim 1, wherein the second adhesive member (320) surrounds the first adhesive member (310).

5. Solar cell apparatus of claim 1, wherein the first adhesive member (310) covers the second adhesive member (320).

6. Solar cell apparatus of claim 1, wherein second adhesive member (320) covers the first adhesive member (310).

7. Solar cell apparatus of claim 1, further comprising a protective panel (400) covering the first adhesive member (310) and the second adhesive member (320), the second adhesive member (320) being adhered to the protective panel (400).

8. Solar cell apparatus of the claim 1, wherein the solar cell panel (100) further comprises a plurality of solar cells (120) disposed in the central region (CR).

9. Solar cell apparatus comprising:
a solar cell panel (100),
a buffer member (310) making direct contact with the top surface of the solar cell panel (100),
an adhesive member (320) disposed on the solar cell panel (100) and adhered to a surrounding region of the buffer member (310) in a top surface of the solar cell panel (100), and
a protective panel (400) disposed on the buffer member (310) and the adhesive member,
**characterized in that** the buffer member (310) and the adhesive member (320) are formed of ethylene vinyl acetate, and
**in that** the ethylene vinyl acetate of the buffer member (310) has a content of vinyl acetate less than the ethylene vinyl acetate of the adhesive member (320).

10. Solar cell apparatus of claim 9, wherein the adhesive member (320) has a closed-loop and surrounds the buffer member (310) .

11. Solar cell apparatus of claim 9, wherein the adhesive member (320) has an area greater than the buffer member (310) and covers side and top surfaces of the buffer member (310).

12. Solar cell apparatus of claim 9, wherein the adhesive member (320) comprises ethylene vinyl acetate which has about 40 wt% to 60 wt% of vinyl acetate.

13. Solar cell apparatus of claim 9, wherein the solar cell panel (100) comprising a central region (CR) and an outer region (OR) surrounding the central region (CR).

14. Solar cell apparatus comprising:
a solar cell panel (100) comprising a central region (CR) and an outer region (OR) around the central region (CR),
an attachable member (310) disposed on the central region (CR),
an adhesive member (320) adhered to the outer region (OR); and
a protective panel (400) covering the attachable member (310) and the adhesive member (320),
**characterized in that** the attachable member (310) and the adhesive member (320) are formed of ethylene vinyl acetate, and
**in that** the ethylene vinyl acetate of the attachable member (310) has a content of vinyl acetate less than the ethylene vinyl acetate of the adhesive member (320).

15. Solar cell apparatus of claim 14, wherein the adhesive member (320) covers the attachable member (310) and is adhered to a bottom surface of the protective panel (400).

16. Solar cell apparatus of claim 14, wherein the attachable member (310) is attachable/detachable to/from the solar cell panel (100).

## Patentansprüche

1. Solarzelleneinrichtung, umfassend:
ein Solarzellenpanel (100), eine zentrale Region (CR) und eine äußere Region (OR), die die zentrale Region (CR) umgibt, umfassend,
ein erstes Haftelement (310), das an der zentralen Region (CR) anhaftet, und
ein zweites Haftelement (320), das an der äußeren Region (OR) anhaftet, und eine Haftfestigkeit stärker als das erste Haftelement (310) aufweist,
wobei das erste Haftelement (310) und das zweite Haftelement (320) aus Ethylenvinylacetat gebildet sind, und
**dadurch gekennzeichnet, dass** das Ethylenvinylacetat des ersten Haftelements (310) einen geringeren Vinylacetatgehalt als das Ethylenvinylacetat des zweiten Haftelements (320) aufweist.

2. Solarzelleneinrichtung nach Anspruch 1,
wobei das Ethylenvinylacetat des ersten Haftelements (310) 15 Gew.-% bis 40 Gew.-% an Vinylacetat umfasst,
wobei das Ethylenvinylacetat, aus dem das zweite Haftelement (320) ist, 40 Gew.-% bis 60 Gew.-% an Vinylacetat aufweist.

3. Solarzelleneinrichtung nach Anspruch 1, wobei das zweite Haftelement (320) eine geschlossene Schleifenform aufweist.

4. Solarzelleneinrichtung nach Anspruch 1, wobei das zweite Haftelement (320) das erste Haftelement (310) umgibt.

5. Solarzelleneinrichtung nach Anspruch 1, wobei das erste Haftelement (310) das zweite Haftelement (320) abdeckt.

6. Solarzelleneinrichtung nach Anspruch 1, wobei das zweite Haftelement (320) das erste Haftelement (310) abdeckt.

7. Solarzelleneinrichtung nach Anspruch 1, weiter ein Schutzpanel (400) umfassend, das das erste Haftelement (310) und das zweite Haftelement (320) abdeckt, wobei das zweite Haftelement (320) an dem Schutzpanel (400) anhaftet.

8. Solarzelleneinrichtung nach Anspruch 1, wobei das Solarzellenpanel (100) weiter eine Vielzahl von Solarzellen (120) umfasst, die in der zentralen Region (CR) angeordnet sind.

9. Solarzelleneinrichtung, umfassend:
ein Solarzellenpanel (100),
ein Pufferelement (310), das direkten Kontakt mit der obersten Oberfläche des Solarzellenpanels (100) herstellt,
ein Haftelement (320), das an dem Solarzellenpanel (100) angeordnet ist und an der umgebenden Region des Pufferelements (310) auf einer obersten Oberfläche des Solarzellenpanels (100) anhaftet, und
ein Schutzpanel (400), das an dem Pufferelement (310) und dem Haftelement angeordnet ist,
**dadurch gekennzeichnet, dass** das Pufferelement (310) und das Haftelement (320) aus Ethylenvinylacetat gebildet sind, und
dadurch, dass das Ethylenvinylacetat des Pufferelements (310) einen geringeren Vinylacetatgehalt als das Ethylenvinylacetat des Haftelements (320) aufweist.

10. Solarzelleneinrichtung nach Anspruch 9, wobei das Haftelement (320) eine geschlossene Schleife aufweist und das Pufferelement (310) umgibt.

11. Solarzelleneinrichtung nach Anspruch 9, wobei das Haftelement (320) einen Bereich größer als das Pufferelement (310) aufweist und Seiten- und oberste Oberflächen des Pufferelements (310) abdeckt.

12. Solarzelleneinrichtung nach Anspruch 9, wobei wobei das Haftelement (320) Ethylenvinylacetat umfasst, das etwa 40 Gew.-% bis 60 Gew.-% an Vinylacetat aufweist.

13. Solarzelleneinrichtung nach Anspruch 9, wobei das Solarzellenpanel (100) eine zentrale Region (CR) und eine äußere Region (OR) umfasst, die die zentrale Region (CR) umgibt.

14. Solarzelleneinrichtung, umfassend:
ein Solarzellenpanel (100), das eine zentrale Region (CR) und eine äußere Region (OR) um die zentrale Region (CR) herum umfasst,
ein anbringbares Element (310), das in der zentralen Region (CR) angeordnet ist,
ein Haftelement (320), das an der äußeren Region (OR) anhaftet; und
ein Schutzpanel (400), das das anbringbare Element (310) und das Haftelement (320) abdeckt,
**dadurch gekennzeichnet, dass** das anbringbare Element (310) und das Haftelement (320) aus Ethylenvinylacetat gebildet wird, und
dadurch, dass das Ethylenvinylacetat des anbringbaren Elements (310) einen geingeren Vinylacetatgehalt als das Ethylenvinylacetat des Haftelements (320) aufweist.

15. Solarzelleneinrichtung nach Aspruch 14, wobei das Haftelement (320) das anbringbare Element (310) abdeckt und an einer Bodenoberfläche des Schutzpanels (400) anhaftet.

16. Solarzelleneinrichtung nach Aspruch 14, wobei das anbringbare Element (310) an/von dem Solarzellenpanel (100) anbringbar/abnehmbar ist.

## Revendications

1. Appareil à cellule solaire comprenant :
un panneau de cellule solaire (100) comprenant une région centrale (CR) et une région externe (OR) encerclant la région centrale (CR),
un premier élément adhésif (310) collé sur la région centrale (CR), et
un second élément adhésif (320) collé sur la région externe (OR) et ayant une force d'adhésion supérieure au premier élément adhésif (310),
dans lequel le premier élément adhésif (310) et le second élément adhésif (320) sont formés d'acétate de vinyle-éthylène, et
**caractérisé en ce que** l'acétate de vinyle-éthylène du premier élément adhésif (310) a une teneur en acétate de vinyle inférieure à l'acétate de vinyle-éthylène du second élément adhésif (320).

2. Appareil à cellule solaire selon la revendication 1,
dans lequel l'acétate de vinyle-éthylène du premier élément adhésif (310) comprend 15 % en poids à 40 % en poids d'acétate de vinyle,
dans lequel l'acétate de vinyle-éthylène qui est du second élément adhésif (320) a 40 % en poids à 60 % en poids d'acétate de vinyle.

3. Appareil à cellule solaire selon la revendication 1, dans lequel le second élément adhésif (320) a une forme en boucle fermée.

4. Appareil à cellule solaire selon la revendication 1, dans lequel le second élément adhésif (320) encercle le premier élément adhésif (310).

5. Appareil à cellule solaire selon la revendication 1, dans lequel le premier élément adhésif (310) recouvre le second élément adhésif (320).

6. Appareil à cellule solaire selon la revendication 1, dans lequel un second élément adhésif (320) recouvre le premier élément adhésif (310).

7. Appareil à cellule solaire selon la revendication 1, comprenant en outre un panneau protecteur (400) recouvrant le premier élément adhésif (310) et le second élément adhésif (320), le second élément adhésif (320) étant collé sur le panneau protecteur (400).

8. Appareil à cellule solaire selon la revendication 1, dans lequel le panneau de cellule solaire (100) comprend en outre une pluralité de cellules solaires (120) disposées dans la région centrale (CR).

9. Appareil à cellule solaire comprenant :
un panneau de cellule solaire (100),
un élément tampon (310) réalisant un contact direct avec la surface supérieure du panneau de cellule solaire (100),
un élément adhésif (320) disposé sur le panneau de cellule solaire (100) et collé sur une région d'encerclement de l'élément tampon (310) dans une surface supérieure du panneau de cellule solaire (100), et
un panneau protecteur (400) disposé sur l'élément tampon (310) et l'élément adhésif,
**caractérisé en ce que** l'élément tampon (310) et l'élément adhésif (320) sont formés d'acétate de vinyle-éthylène, et
**en ce que** l'acétate de vinyle-éthylène de l'élément tampon (310) a une teneur en acétate de vinyle inférieure à l'acétate de vinyle-éthylène de l'élément adhésif (320) .

10. Appareil à cellule solaire selon la revendication 9, dans lequel l'élément adhésif (320) a une boucle fermée et encercle l'élément tampon (310).

11. Appareil à cellule solaire selon la revendication 9, dans lequel l'élément adhésif (320) a une aire supérieure à l'élément tampon (310) et recouvre les surfaces latérales et supérieure de l'élément tampon (310) .

12. Appareil à cellule solaire selon la revendication 9, dans lequel l'élément adhésif (320) comprend de l'acétate de vinyle-éthylène qui a environ 40 % en poids à 60 % en poids d'acétate de vinyle.

13. Appareil à cellule solaire selon la revendication 9, dans lequel le panneau de cellule solaire (100) comprend une région centrale (CR) et une région externe (OR) encerclant la région centrale (CR).

14. Appareil à cellule solaire comprenant :
un panneau de cellule solaire (100) comprenant une région centrale (CR) et une région externe (OR) autour de la région centrale (CR),
un élément apte à être attaché (310) disposé sur la région centrale (CR),
un élément adhésif (320) collé sur la région externe (OR) ; et
un panneau protecteur (400) recouvrant l'élément apte à être attaché (310) et l'élément adhésif (320),
**caractérisé en ce que** l'élément apte à être attaché (310) et l'élément adhésif (320) sont formés d'acétate de vinyle-éthylène, et
**en ce que** l'acétate de vinyle-éthylène de l'élément apte à être attaché (310) a une teneur en acétate de vinyle inférieure à l'acétate de vinyle-éthylène de l'élément adhésif (320).

15. Appareil à cellule solaire selon la revendication 14, dans lequel l'élément adhésif (320) recouvre l'élément apte à être attaché (310) et est collé sur une surface inférieure du panneau protecteur (400).

16. Appareil à cellule solaire selon la revendication 14, dans lequel l'élément apte à être attaché (310) est apte à être attaché/détaché sur le/à partir du panneau de cellule solaire (100).
